# EUROPEAN PATENT APPLICATION

(11) **EP 4 672 281 A1**
(43) Date of publication of application: **31.12.2025**
(21) Application number: 25177443.6
(22) Date of filing: 19.05.2025
(51) Int. Cl.: H01F 27/02, H05K 7/20, H01F 27/10, H01F 27/22, H01F 27/26, H01F 27/30, H01F 37/00, H02M 7/00

(54) **ENERGY STORAGE CONVERTER**

(30) Priority: 25.06.2024 CN 202410823976
(71) Applicant: Zhejiang Jinko Energy Storage Co., Ltd., Jiaxing, Zhejiang (CN)
(72) Inventor: ZHANG, Luhua, Haining (CN); YU, Jian, Haining (CN)
(74) Representative: Balder IP Law, S.L.

(57) **Abstract**

Provided is an energy storage converter. The energy storage converter includes a housing, a liquid cooling plate and an inductor. The housing is internally provided with an accommodating space. The liquid cooling plate is located within the accommodating space. The inductor includes an outer shell and an inner core. The outer shell includes a first side plate, a second side plate, a third side plate, a fourth side plate, a fifth side plate and a sixth side plate. The fifth side plate is provided with an opening, a wire outlet structure is disposed on a portion of the fifth side plate other than the opening and extends in a direction from the opening to the sixth side plate, and the fifth side plate is fixed on a surface of the liquid cooling plate.

## Description

### TECHNICAL FIELD

Embodiments of the present disclosure relate to the field of energy storage, and particularly to an energy storage converter.

### BACKGROUND

With a continuous development of the power industry, an operating power of an electric energy conversion device is increasing. To ensure a normal operation of the electric energy conversion device, it is necessary to allow an inductor connected to the electric energy conversion device to operate in a low-temperature environment, which imposes increasingly higher requirements on a heat dissipation of the inductor in the electric energy conversion device.

In the related art, the inductor in the energy storage converter is a commonly used electronic component, and the heat dissipation of the inductor is typically achieved through air cooling. In the air cooling, cold air also cools other components within a container, leading to a poor dissipation effect of the inductor. As a result, the inductor operates in a high-temperature environment for a long time, which affects a service life of the inductor.

Therefore, improvement of the heat dissipation effect of the inductor in the energy storage converter is desired.

### SUMMARY

Embodiments of the present disclosure provide an energy storage converter, which can at least accelerate a heat dissipation of the inductors in the energy storage converter.

According to some embodiments of the present disclosure, an aspect of the embodiments of the present disclosure provides an energy storage converter. The energy storage converter includes a housing, a liquid cooling plate and an inductor. The housing is internally provided with an accommodating space. The liquid cooling plate is located within the accommodating space. The inductor includes an outer shell and an inner core. The outer shell includes a first side plate and a second side plate arranged along a first direction, a third side plate and a fourth side plate arranged along a second direction, and a fifth side plate and a sixth side plate arranged along a third direction. The fifth side plate is provided with an opening, a wire outlet structure is disposed on a portion of the fifth side plate other than the opening and extends in a direction from the opening to the sixth side plate, and the fifth side plate is fixed on a surface of the liquid cooling plate. The inner core is fixed inside the outer shell. An output line of the inner core extends out of the outer shell from the wire outlet structure.

In some embodiments, the outer shell further includes: a limiting structure, located on a side of the inner core away from the sixth side plate and surrounding the wire outlet structure.

In some embodiments, the inner core includes: a magnetic core and a coil surrounding part of the magnetic core. The limiting structure includes a fixing portion and a plurality of copper bars. A surface of the fixing portion facing the sixth side plate abuts the inner core. The plurality of copper bars are fixed on the fixing portion. A respective copper bar of the plurality of copper bars is provided with a first through hole penetrating the respective copper bar, the first through hole is aligned with the wire outlet structure, and the output line is electrically connected to the respective copper bar, and passes through the first through hole to extend into the wire outlet structure.

In some embodiments, the limiting structure further includes a clamping portion and/or two limiting portions. The clamping portion is fixed on a surface of the fixing portion away from the sixth side plate, a second through hole is provided between the clamping portion and the fixing portion, and the respective copper bar passes through the second through hole and is fixed on the fixing portion. The two limiting portions are located on opposite sides of the fixing portion respectively, and each of the two limiting portions abuts both the fixing portion and the magnetic core.

In some embodiments, the clamping portion includes a plurality of first extending portions, a plurality of first bending portions, and at least one second extending portion. The plurality of first extending portions extend along the first direction. Each respective first extending portion of the plurality of first extending portions at least covers a surface of the respective copper bar away from the sixth side plate. Each respective first bending portion of the plurality of first bending portions is connected to one end of the respective first extending portion and extends toward the coil in the second direction. The at least one second extending portion extend along the first direction. Each respective second extending portion of the at least one second extending portion is located between two adjacent first extending portions and connected to a respective first bending portions, and the respective second extending portion is located on a side of each of the two adjacent first extending portions facing the coil.

In some embodiments, each of the two limiting portions includes a first contact portion and a second contact portion. The first contact portion extends along the first direction and abuts the fixing portion. The second contact portion extends along the third direction and abuts a part of the magnetic core not surrounded by the coil.

In some embodiments, the first contact portion includes: a plurality of sub-contact portions, arranged along the third direction; and a connecting portion, extending along the third direction Z and configured to connect the plurality of sub-contact portions together.

In some embodiments, the fixing portion includes a bearing portion and an abutting portion. The plurality of copper bars are fixed on the bearing portion. The abutting portion is located on a surface of the bearing portion facing the sixth side plate. In the second direction, a length of an orthographic projection of each of the plurality of copper bars on the bearing portion is greater than a length of an orthographic projection of the abutting portion on the bearing portion.

In some embodiments, the inductor further includes a filling layer. The filling layer fills the outer shell, and the inner core is located between the filling layer and the outer shell.

In some embodiments, the energy storage converter further includes a heat conduction layer located between the filling layer and the liquid cooling plate.

In some embodiments, the inductor further includes a radiating fin fixed on a surface of the outer shell.

In some embodiments, a connection surface between each of at least one of the first side plate and the second side plate and each of the third side plate, the fourth side plate and the sixth side plate is rounded.

In some embodiments, the first side plate is connected to each of the third side plate, the fourth side plate and the sixth side plate through a connecting step.

In some embodiments, the connecting step includes a first connecting side wall and a second connecting side wall. The first connecting side wall is connected to the first side plate. The second connecting side wall is connected to each of the third side plate, the fourth side plate and the sixth side plate. There is an included angle between the first connecting side wall and the second connecting side wall.

In some embodiments, the first connecting side wall includes a first connecting region, a second connecting region, and a third connecting region. The first connecting region is in contact with a side surface of the first side plate away from the fifth side plate. The second connecting region is connected to the first connecting region and in contact with a side surface of the first side plate on one of two opposing sides of the first side plate. The third connecting region is connected to the first connecting region and in contact with a side surface of the first side plate on the other one of two opposing sides of the first side plate.

### BRIEF DESCRIPTION OF THE DRAWINGS

One or more embodiments are exemplarily described with reference to the corresponding figures in the accompanying drawings, and the exemplary descriptions are not to be construed as limiting the embodiments. Unless otherwise particularly stated, the figures in the accompanying drawings are not drawn to scale. To describe the technical solutions in the embodiments of the present disclosure or in the conventional technologies more clearly, the following briefly introduces the accompanying drawings required for describing the embodiments. Apparently, the accompanying drawings in the following description show merely some embodiments of the present disclosure, and a person of ordinary skill in the art can still derive other accompanying drawings from these accompanying drawings without creative efforts.
FIG. 1 is a perspective drawing of an energy storage converter according to an embodiment of the present disclosure.
FIG. 2 is a perspective view of an inductor according to an embodiment of the present disclosure.
FIG. 3 is another perspective view of an inductor according to an embodiment of the present disclosure.
FIG. 4 is a perspective view of an inner core according to an embodiment of the present disclosure.
FIG. 5 is yet another perspective view of an inductor according to an embodiment of the present disclosure.
FIG. 6 is a schematic structure view illustrating engagement of a limiting structure with an inner core according to an embodiment of the present disclosure.
FIG. 7 is another schematic structure view illustrating engagement of a limiting structure with an inner core according to an embodiment of the present disclosure.
FIG. 8 is still yet another perspective view of an inductor according to an embodiment of the present disclosure.
FIG. 9 is a schematic exploded view of an inductor and a heat conduction layer according to an embodiment of the present disclosure.

### DETAILED DESCRIPTION

As can be seen from the background, an existing inductor typically relies on air cooling for heat dissipation, where an opening of the inductor needs to be oriented toward an airflow source to facilitate heat dissipation via forced-air convection.

Embodiments of the present disclosure provide an energy storage converter. The components in the energy storage converter are protected by the housing and cooled by the liquid cooling plate. The outer shell of the inductor is provided to include multiple side plates defining the outer shell, so as to protect the inner core of the inductor. The fifth side plate is provided with an opening, and disposed on the liquid cooling plate so that the opening is oriented toward the liquid cooling plate, which reduces a distance between the inner core and the liquid cooling plate, thereby increasing a cooling rate of the inner core and improving a heat dissipation efficiency of the inductor in the energy storage converter. Additionally, a wire outlet structure is disposed on a portion of the fifth side plate other than the opening and extends in a direction from the opening to the sixth side plate, so that when the fifth side plate is fixed on a surface of the liquid cooling plate, electric connection of the output line of the inner core to other structures is facilitated, a position of the output line is fixed, and a design of an installation location of the inductor is also facilitated.

In the description of the embodiments of the present disclosure, the technical terms "first" "second" and the like are only used to distinguish different objects and cannot be understood as indicating or implying relative importance or implicitly indicating the number, specific order, or primary and secondary relationship of the indicated technical features. In the description of the embodiments of the present disclosure, "a plurality of" means at least two, unless otherwise specified.

Reference herein to "embodiment" means that a particular feature, structure, or characteristic described in connection with the embodiment may be included in at least one embodiment of the present disclosure. The appearances of this phrase in various places in the specification are not necessarily all referring to the same embodiment, nor are separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" is merely an association relationship describing associated objects, indicating that there may be three relationships, for example, A and/or B, which may indicate that A exists, A and B exist at the same time, and B exists. In addition, the character "/" in this specification generally indicates an "or" relationship between the associated objects.

In the description of the embodiments of the present disclosure, the term "a plurality of" means at least two, similarly, "a plurality of groups" means at least two groups, and "a plurality of pieces" means at least two pieces.

In the description of the embodiments of the present disclosure, orientation or positional relationship indicated by technical terms "center", "transverse", "longitudinal", "length", "width", "thickness", "up", "down", "front", "rear", "left", "right", "vertical", "horizontal", "top", "bottom", "inside" "outside", "clockwise", "counterclockwise", "axial", "radial", "circumferential" and the like are orientations or positional relationships based on those shown in the accompanying drawings, which are intended only to facilitate the description of embodiments of the present disclosure and to simplify the description, and are not intended to indicate or imply that the device or element referred to must have a particular orientation, be constructed and operated with a particular orientation, and therefore are.

In the description of the embodiments of the present disclosure, unless otherwise specified and limited, technical terms "mounted", "connected", "connecting", "fixed", etc. are to be understood in a broad sense. For example, it may be a fixed connection, a removable connection, or a one-piece connection, it may be a mechanical connection, or an electrical connection, it may be a direct connection, or an indirect connection through an intermediate medium, and it may be a connection between two elements or an interaction between the two elements. For those of ordinary skill in the art, specific meanings of the above terms in the embodiments of the present disclosure may be understood according to specific situations.

In the accompanying drawings corresponding to the embodiments of the present disclosure, for better understanding and ease of description, the thickness and area of a layer are enlarged. When a component (e.g., a layer, a film, a region, or a substrate) is described as being formed over another component or over a surface of another component, the component may be "directly" on the surface of another component, or a third component may exist between the two components. In contrast, when a component is described as being formed on a surface of another component or a surface of a component is formed or provided with another component, there is no third component between the two components. In addition, when a component is described as being "substantially" formed on/over another component, it means that the component is not formed on/over the entire surface (or front surface) of another component, nor on/over a portion of the edge of the entire surface.

In the description of the embodiments of the present disclosure, when a component "includes" another component, unless otherwise stated, other components are not excluded, and other components may be further included in the component. In addition, when a component such as a layer, a film, a region, or a plate is referred to as being "over/disposed over" another component, it may be "directly on" another component (i.e., being on the surface of another component and there is no other component therebetween), or another component may exist therebetween. Furthermore, when a component such as a layer, film, region, plate, etc. is "directly on" another component, or when a component such as a layer, film, region, plate, etc. is disposed on the surface of another component, it means that no other component is disposed therebetween.

The terminology used in the description of the various described embodiments herein is for the purpose of describing particular embodiments only and is not intended to be limiting. As used in the description of the various embodiments described and the appended claims, "the portion" is also intended to include the plural forms as well, unless the context clearly indicates otherwise. The component includes a layer, a film, a region, or a plate, etc.

The following describes the embodiments of the present disclosure in detail with reference to the accompanying drawings. However, a person of ordinary skill in the art may understand that in the embodiments of the present disclosure, many technical details are provided to make readers better understand the embodiments of the present disclosure. However, even without these technical details and various changes and modifications based on the following embodiments, the technical solutions claimed in the embodiments of the present disclosure can be implemented.

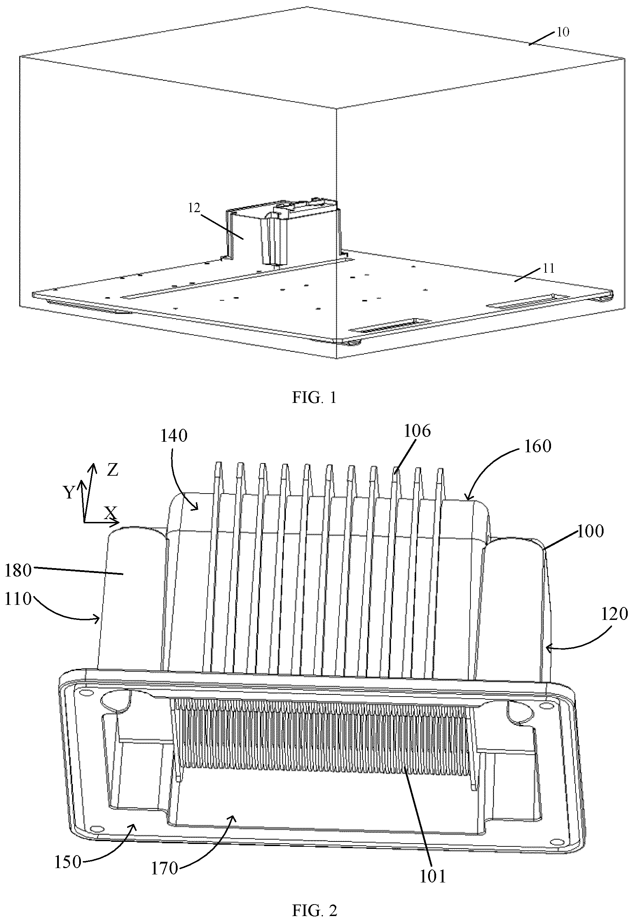

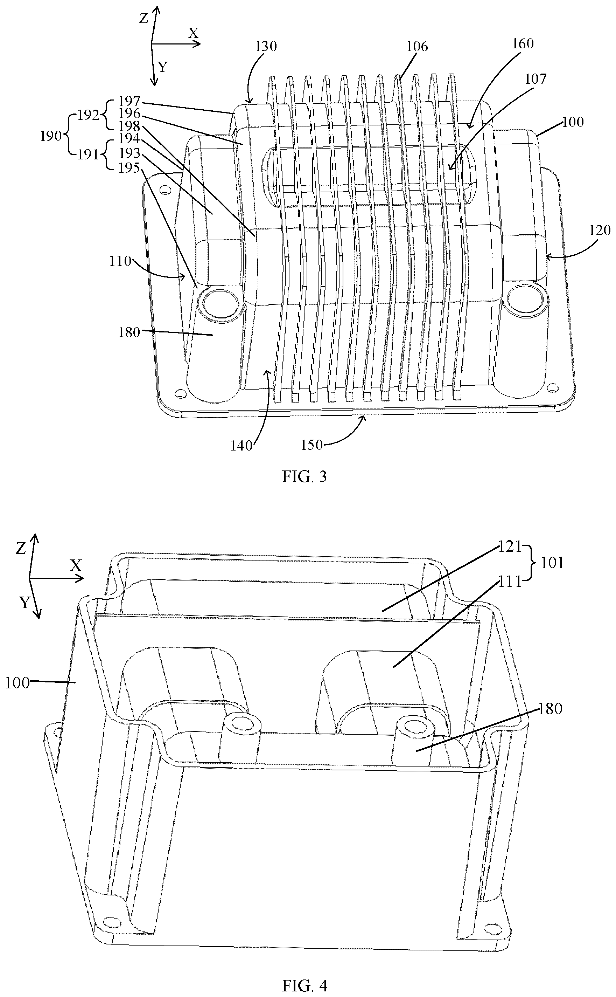

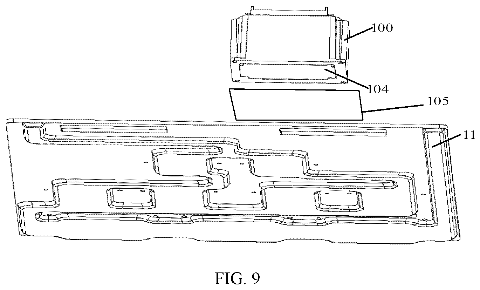

Referring to FIGS. 1, 2, 3 and 9, FIG. 1 is a perspective drawing of an energy storage converter according to an embodiment of the present disclosure, FIG. 2 is a perspective view of an inductor according to an embodiment of the present disclosure, FIG. 3 is another perspective view of an inductor according to an embodiment of the present disclosure, and FIG. 9 is a schematic exploded view of an inductor and a heat conduction layer according to an embodiment of the present disclosure.

In some embodiments, the energy storage converter may include: a housing 10, with an accommodating space provided inside the housing 10.

The energy storage converter may further include: a liquid cooling plate 11, located within the accommodating space.

The energy storage converter may further include an inductor 12. The inductor 12 may include an outer shell 100 and an inner core 101. The outer shell 100 includes a first side plate 110 and a second side plate 120 arranged along a first direction X, a third side plate 130 and a fourth side plate 140 arranged along a second direction Y, and a fifth side plate 150 and a sixth side plate 160 arranged along a third direction Z. The fifth side plate 150 is provided with an opening 170, a wire outlet structure 180 is disposed on a portion of the fifth side plate 150 other than the opening 170 and extends in a direction from the opening 170 to the sixth side plate 160, and the fifth side plate 150 is fixed on a surface of the liquid cooling plate 11. The inner core 101 is fixed inside the outer shell 100, and an output line of the inner core 101 extends out of the outer shell 100 from the wire outlet structure 180.

In the embodiments of the present disclosure, the components in the energy storage converter are protected by the housing 10 and cooled by the liquid cooling plate 11. The outer shell 100 of the inductor 12 is provided to include multiple side plates defining the outer shell 100, so as to protect the inner core 101 of the inductor 12. The fifth side plate 150 is provided with an opening 170, and disposed on the liquid cooling plate 11 so that the opening 170 is oriented toward the liquid cooling plate 11, which reduces a distance between the inner core 101 and the liquid cooling plate 11, thereby increasing a cooling rate of the inner core 101 and improving a heat dissipation efficiency of the inductor in the energy storage converter. Additionally, a wire outlet structure 180 is disposed on a portion of the fifth side plate 150 other than the opening 170 and extends in a direction from the opening 170 to the sixth side plate 160, so that when the fifth side plate 150 is fixed on a surface of the liquid cooling plate 11, electric connection of the output line of the inner core 101 to other structures is facilitated, a position of the output line is fixed, and a design of an installation location of the inductor is also facilitated.

In some embodiments, the inductor 12 is installed on the liquid cooling plate 11, with the fifth side plate 150 in contact with a surface of the liquid cooling plate 11. This allows a heat exchange between the inner core 101 of the inductor 12 and the liquid cooling plate 11 to be performed through the opening 170, avoiding that the inductor 12 is separated from a cooling source by the outer shell 100. This reduces a distance between the inductor 12 and the cooling source, improving the heat dissipation efficiency of the inductor 12.

In some embodiments, for the first side plate 110, it is connected to the third side plate 130, the fourth side plate 140, the fifth side plate 150, and the sixth side plate 160. A connection surface between the first side plate 110 and the third side plate 130 may be rounded. Similarly, a connection surface between the first side plate 110 and the fourth side plate 140 may be rounded, and a connection surface between the first side plate 110 and the sixth side plate 160 may be rounded.

In some embodiments, for the second side plate 120, it is connected to the third side plate 130, the fourth side plate 140, the fifth side plate 150, and the sixth side plate 160. A connection surface between the second side plate 120 and the third side plate 130 may be rounded. Similarly, a connection surface between the second side plate 120 and the fourth side plate 140 may be rounded, and a connection surface between the second side plate 120 and the sixth side plate 160 may be rounded.

In some embodiments, for the third side plate 130, it is connected to the first side plate 110, the second side plate 120, the fifth side plate 150, and the sixth side plate 160. A connection surface between the third side plate 130 and the sixth side plate 160 may be rounded.

In some embodiments, for the fourth side plate 140, it is connected to the first side plate 110, the second side plate 120, the fifth side plate 150, and the sixth side plate 160. A connection surface between the fourth side plate 140 and the sixth side plate 160 may be rounded.

As described above, the first side plate 110, the second side plate 120, the third side plate 130, the fourth side plate 140, the fifth side plate 150, and the sixth side plate 160 are connected to form the outer shell 100.

Moreover, for the opening 170, a size of the opening 170 may be the same as a size of a space defined by the first side plate 110, the second side plate 120, the third side plate 130, and the fourth side plate 140. In other words, the fifth side plate 150 may be in contact with outer surfaces of the first side plate 110, the second side plate 120, the third side plate 130, and the fourth side plate 140, exposing an entire inner core 101 through the opening 170, thereby further improving the heat dissipation efficiency of the inner core 101.

Referring to FIGS. 2 and 3, in some embodiments, the first side plate 110 may be connected to the sixth side plate 160 via a connecting step 190. Similarly, the first side plate 110 may be connected to each of the third side plate 130 and the fourth side plate 140 via the connecting step 190.

The second side plate 120 may be connected to the sixth side plate 160 via a connecting step 190. Similarly, the second side plate 120 may be connected to each of the third side plate 130 and the fourth side plate 140 via the connecting step 190.

In some embodiments, the connecting step 190 may include: a first connecting side wall 191 connected to the first side plate 110; and a second connecting side wall 192 connected to each of the third side plate 130, the fourth side plate 140 and the sixth side plate 160. There is an included angle between the first connecting side wall 191 and the second connecting side wall 192.

In some embodiments, the first connecting side wall 191 may include: a first connecting region 193 in contact with a side surface of the first side plate 110 away from the fifth side plate 150; a second connecting region 194, connected to the first connecting region 193 and in contact with a side surface of the first side plate 110 on one of two opposing sides of the first side plate 110; and a third connecting region 195, connected to the first connecting region 193 and in contact with a side surface of the first side plate 110 on the other one of two opposing sides of the first side plate 110.

In some embodiments, the first connecting region 193, the second connecting region 194, and the third connecting region 195 may be of an integrated structure. A connection surface between the first connecting region 193 and the second connecting region 194 may be rounded, and a connection surface between the first connecting region 193 and the third connecting region 195 may be rounded, thereby improving the reliability of the first connecting side wall 191, avoiding sharp edges between the first connecting region 193 and the second connecting region 194 and between the first connecting region 193 and the third connecting region 195 to reduce a likelihood of wear on the outer shell 100. Additionally, an integrated structure of the first connecting side wall 191 increases the strength and connection reliability of the first connecting side wall 191.

In some embodiments, the first connecting region 193, the second connecting region 194, and the third connecting region 195 may be of a split structure. That is, the first connecting region 193, the second connecting region 194, and the third connecting region 195 may be connected to each other via welding or the like.

In some embodiments, the second connecting side wall 192 may include: a fourth connecting region 196 connected to each of the sixth side plate 160 and the first connecting region 193; a fifth connecting region 197 connected to each of the fourth connecting region 196, the third side plate 130 and the second connecting region 194; and a sixth connecting region 198 connected to each of the fourth connecting region 196, the fourth side plate 140 and the third connecting region 195.

In some embodiments, the fourth connecting region 196, the fifth connecting region 197, and the sixth connecting region 198 may be of an integrated structure. A connection surface between the fifth connecting region 197 and the fourth connecting region 196 may be rounded, and a connection surface between the sixth connecting region 198 and the fourth connecting region 196 may be rounded, improving the reliability of the second connecting side wall 192, avoiding sharp edges between the fifth connecting region 197 and the fourth connecting region 196 and between the sixth connecting region 198 and the fourth connecting region 196 to reduce a likelihood of wear on the outer shell 100. Additionally, an integrated structure of the second connecting side wall 192 increases the strength and connection reliability of the second connecting side wall 192.

In some embodiments, the fourth connecting region 196, the fifth connecting region 197 and the sixth connecting region 198 may be of a separate structure. That is, the fourth connecting region 196, the fifth connecting region 197 and the sixth connecting region 198 may be connected to each other via welding or the like.

The connecting step 190 is provided to include a first connecting side wall 191 and a second connecting side wall 192 so that the first side plate 110 can be connected to the third side plate 130, the fourth side plate 140 and the sixth side plate 160. The connecting step 190 can reduce an area of the first side plate 110, thereby reducing a space occupied by the outer shell 100 and lowering an installation space required for the inductor 12.

The first connecting side wall 191 is provided to include the first connecting region 193, the second connecting region 194 and the third connecting region 195, and the second connecting side wall 192 is provided to include the fourth connecting region 196, the fifth connecting region 197, and the sixth connecting region 198, so that the connecting step 190 not only connects different side plates but also improves a sealing of the outer shell, preventing foreign objects from entering an inner space of the outer shell 100 and contaminating the inner core 101.

With continued reference to FIG.3, in some embodiments, in a cross-section perpendicular to the first direction X, a cross-sectional area of a space defined by the third side plate 130, the fourth side plate 140, the fifth side plate 150 and the sixth side plate 160 is larger than an area of the first side plate 110. In other words, along the third direction Z, a top surface of the sixth side plate 160 is higher than a top surface of the first side plate 110, and along the second direction Y, a side surface of each of the third side plate 130 and the fourth side plate 140 protrude beyond end surfaces of the first side plate 110.

FIG. 4 is a perspective view of an inner core according to an embodiment of the present disclosure, showing the inner core installed in the outer shell.

In some embodiments, the inner core 101 may include: a magnetic core 111 and a coil 121 surrounding part of the magnetic core 111. For the inner core 101, the inner diameter of a part of the inner core 101 with the coil 121 increases. A shape of the outer shell 100 is similar to a shape of the inner core 101. Correspondingly, there is a step between the first side plate 110 and the third side plate 130, there is a step between the second side plate 120 and the third side plate 130, there is a step between the first side plate 110 and the fourth side plate 140, there is a step between the second side plate 120 and the fourth side plate 140, there is a step between the first side plate 110 and the sixth side plate 160, and there is a step between the second side plate 120 and the sixth side plate 160. In this way, a space defined by the third side plate 130, the fourth side plate 140 and the sixth side plate 160 is larger and corresponds to the part of the magnetic core 111 surrounded by the coil 121, facilitating an installation of the inner core 101.

Corresponding to the inner core 101, the space defined by the third side plate 130, the fourth side plate 140, the fifth side plate 150, and the sixth side plate 160 is larger than the area of the first side plate 110. This also allows the shape of the outer shell 100 to be similar to that of the inner core 101 to match the outer shell 100 with the inner core 101, facilitating a positioning of the inner core 101 while reducing an installation space required for the inductor 12.

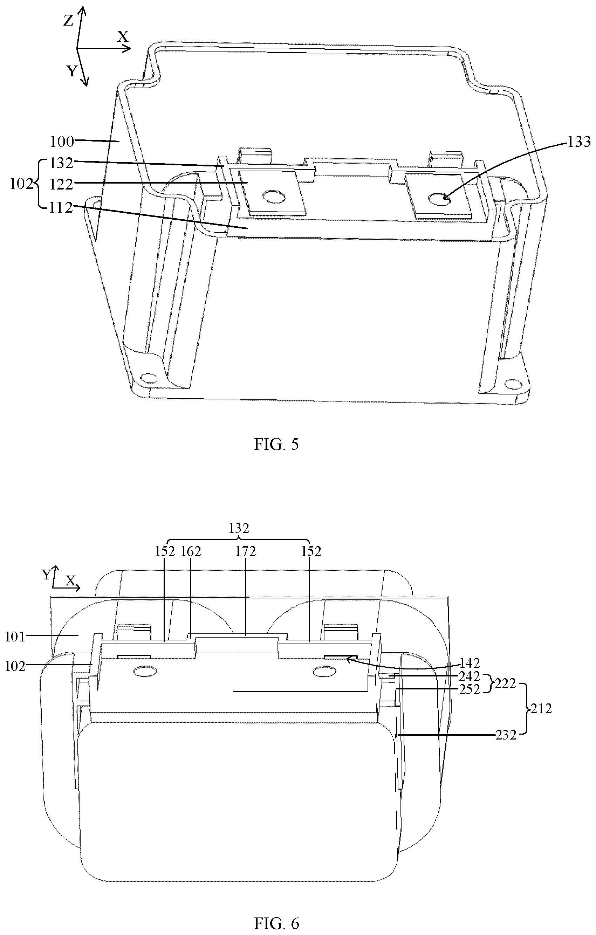

Reference is made to FIGS. 3 to 5, where FIG. 5 is another perspective view of an inductor according to an embodiment of the present disclosure.

In some embodiments, the outer shell 100 further includes: a limiting structure 102 located on a side of the inner core 101 away from the sixth side plate 160 and surrounding the wire outlet structure 180. By providing the limiting structure 102, the inner core 101 can be fixed inside the outer shell 100, preventing the inner core 101 from moving within the outer shell 100.

In some embodiments, the inner core 101 includes: a magnetic core 111 and a coil 121 surrounding part of the magnetic core 111. The limiting structure 102 includes a fixing portion 112 and a plurality of copper bars 122 A surface of the fixing portion 112 facing the sixth side plate 160 abuts the inner core 101, and each copper bar 122 is fixed on the fixing portion 112 and provided with a first through hole 133 penetrating the copper bar 122 and aligned with the wire outlet structure 180. The output line of the inner core 101 is electrically connected to the copper bar 122, and passes through the first through hole 133 to extend into the wire outlet structure 180. By providing the fixing portion 112 which abuts the inner core 101, the inner core 101 is positioned within the outer shell 100. The copper bars 122 improve the stability of the output of the inner core 101, facilitating an electrical connection between the inner core 101 and an other structure.

Reference is made to FIGS. 5 and 6, where FIG. 6 is a schematic structure view illustrating engagement of the limiting structure with the inner core according to an embodiment of the present disclosure.

In some embodiments, the limiting structure 102 further includes a clamping portion 132 fixed on a surface of the fixing portion 112 away from the sixth side plate 160. A second through hole 142 is provided between the clamping portion 132 and the fixing portion 112. The copper bar 122 passes through the second through hole 142 to be fixed on the fixing portion 112. The clamping portion 132 is configured to secure the copper bar 122, preventing the copper bar 122 from moving, and thereby improving the reliability of a connection between the copper bar 122 and the inner core 101.

In some embodiments, the clamping portion 132 may include: multiple first extending portions 152, multiple first bending portions 162, and at least one second extending portion 172. Each first extending portion 152 extends along the first direction X, and at least covers a surface of the copper bar 122 away from the sixth side plate 160. Each first bending portion 162 is connected to one end of the first extending portion 152 and extends along the second direction Y toward the coil 121. Each second extending portion 172 extends along the first direction X, is located between two adjacent first extending portions 152, connected to an adjacent first bending portion 162, and located on a side of the first extending portion 152 facing the coil 121. With the first extending portions 152, securing of the copper bar 122 is facilitated. The second extending portion 172 can separate different magnetic cores 111 and coils, improving the reliability of the inductor 12. The first bending portion 162 connects the first extending portion 152 and the second extending portion 172, enhancing the reliability of the clamping portion 132.

In some embodiments, one inner core 101 includes two coils 121 arranged along the first direction X. The second extending portion 172 is provided between the two coils 121 so that a direct contact between the two coils 121 is avoided, and a reliability of the inductor 12 is improved.

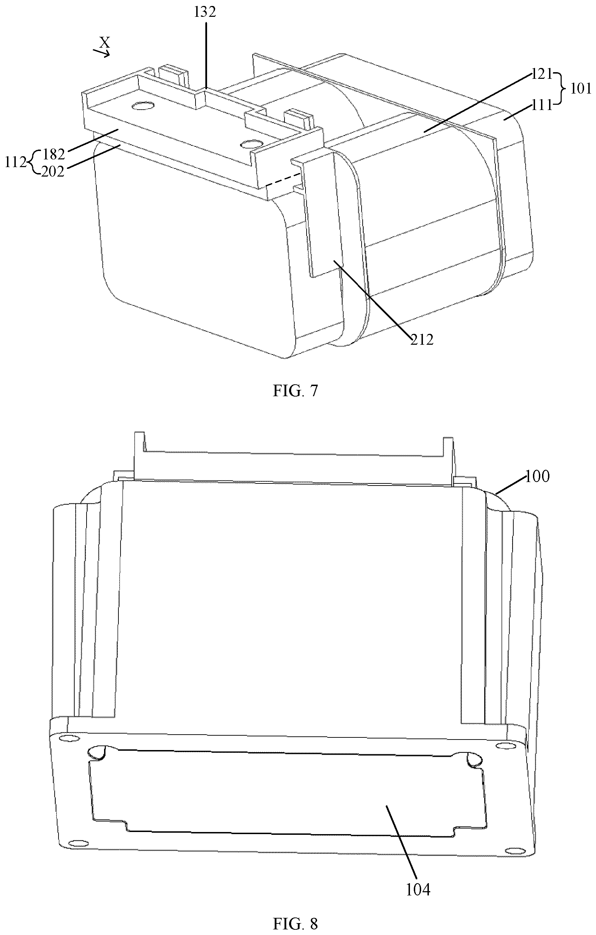

Reference is made to FIGS. 6 and 7, where FIG. 7 is another schematic structure view illustrating engagement of a limiting structure with an inner core according to an embodiment of the present disclosure.

In some embodiments, the fixing portion 112 may include: a bearing portion 182, with the copper bar 122 fixed on the bearing portion 182; and an abutting portion 202 located on a surface of the bearing portion 182 facing the sixth side plate 160. Along the second direction Y, a length of an orthographic projection of the copper bar 122 on the surface of the bearing portion 182 is greater than a length of an orthographic projection of the abutting portion 202 on the surface of the bearing portion 182. The bearing portion 182 may be configured as a platform for installing the copper bar 122, facilitating a placement of the copper bar 122. The length of the abutting portion 202 along the second direction Y is provided to be shorter than the length of the bearing portion 182 along the second direction Y so that a material consumption of the fixing portion 112 is reduced, thereby reducing the cost of the inductor 12.

In some embodiments, the limiting structure 102 further includes: two limiting portions 212 respectively located on two opposite sides of the fixing portion 112 and abutting both the fixing portion 112 and the magnetic core 111. With the limiting portion 212, the fixing portion 112 and the magnetic core 111 are fixed along the first direction X, preventing the fixing portion 112 and the magnetic core 111 from moving in the first direction X, thereby improving the reliability of the limiting structure 102.

In some embodiments, the limiting portion 212 includes a first contact portion 222 and a second contact portion 232. The first contact portion 222 extends along the first direction X and abuts the fixing portion 112. The second contact portion 232 extends along the third direction Y and abuts a part of the magnetic core 111 not surrounded by the coil 121. The first contact portion 222 abuts the fixing portion 112 so that movement of the fixing portion 112 along the first direction X is restricted. The second contact portion 232 abuts the magnetic core 111 so that movement of the magnetic core 111 along the first direction X is restricted, thereby achieving limiting of the inner core 101 by the limiting portion 212 and improving the reliability of the inductor 12.

In some embodiments, the first contact portion 222 may include: multiple sub-contact portions 242 arranged along the third direction Z, and a connecting portion 252 extending along the third direction Z. The connecting portion 252 is configured to connect the multiple sub-contact portions 242 together. It can be understood that the greater the number of sub-contact portions 242, the larger a contact area between the first contact portion 222 and the fixing portion 112, and the stronger the limiting capability. Additionally, some sub-contact portions 242 may serve as reinforcing ribs for the first contact portion 222, increasing the strength of the first contact portion 222.

Correspondingly, increasing the number of sub-contact portions 242 requires a greater quantity of material for the sub-contact portions 242, which in turn incurs higher material costs. Moreover, given a certain surface area of the fixing portion 112 in contact with the first contact portion 222, the number of sub-contact portions 242 is limited. Therefore, the number of sub-contact portions 242 can be selected based on actual conditions, such as 2 to 5.

In some embodiments, the sub-contact portions 242 and the connecting portion 252 may be of an integrated structure, improving a connection strength between the sub-contact portions 242 and the connecting portion 252. In some embodiments, the sub-contact portions 242 and the connecting portion 252 may be of a split structure.

In some embodiments, an entire side wall of the second contact portion 232 abuts the inner core 101, increasing the limiting capability of the second contact portion 232 to further restrict the movement of the inner core 101, and thereby further improving the reliability of the inductor 12.

In some embodiments, the second contact portion 232 and the first contact portion 222 may be of an integrated structure, improving a connection strength between the second contact portion 232 and the first contact portion 222. Further, the second contact portion 232, sub-contact portions 242 and connecting portion 252 may be of an integrated structure, increasing the strength of the limiting portion 212. In some embodiments, the second contact portion 232 and the first contact portion 222 may be of a split structure, which can be selected based on actual conditions.

Reference is made to FIGS. 4 and 8, where FIG. 8 is still yet another perspective view of an inductor according to an embodiment of the present disclosure.

In some embodiments, the inductor 12 may further include a filling layer 104 filling the outer shell 100. The inner core 101 is located between the filling layer 104 and the outer shell 100. On one hand, the filling layer 104 expels air from the outer shell 100. For the inner core 101, air with a low thermal conductivity is not conducive to heat dissipation. Therefore, by providing the filling layer 104 to expel air from the outer shell 100, a conduction of heat from the inner core 101 is facilitated, and heat from the inner core 101 can be more easily dissipated. On the other hand, the filling layer 104 also helps secure the inner core 101 within the outer shell 100, improving the reliability of fixing of the inner core 101.

Reference is made to FIG. 9, where FIG. 9 is a schematic exploded view of an inductor and a heat conduction layer according to an embodiment of the present disclosure.

In some embodiments, the inductor 12 may further include a heat conduction layer 105 located on a surface of the filling layer 104. The heat conduction layer 105 has a high thermal conductivity, facilitating a conduction of heat from the inner core 101 and a dissipation of heat from the inner core 101.

In some embodiments, the inductor 12 is fixed on a surface of the liquid cooling plate 11, with the heat conduction layer 105 placed on the surface of the liquid cooling plate 11. This allows heat from the inner core 101 to be transferred to the liquid cooling plate 11, facilitating a heat exchange between the inner core 101 and the liquid cooling plate 11. Moreover, in the embodiments of the present disclosure, there is no side wall of the outer shell between the inner core 101 and the liquid cooling plate 11, further enhancing the heat dissipation capability of the inner core 101.

With continued reference to FIGS. 2 and 3, in some embodiments, the inductor 12 may further include a radiating fin 106 fixed on the surface of the outer shell 100. By providing the radiating fin 106, air turbulence is increased, further enhancing heat exchange between the inductor 12 and the air, and thus improving the heat dissipation effect of the inductor 12.

In some embodiments, the radiating fin 106 is disposed on surfaces of the third side plate 130, the fourth side plate 140, and the sixth side plate 160. The radiating fin 106 disposed on the surfaces of the third side plate 130, the fourth side plate 140, and the sixth side plate 160 increases a contact area between the inductor 12 and the air, enhancing the heat dissipation capability of the inductor 12. In some embodiments, the radiating fin 106 may be disposed on only the surface of the sixth side plate 160, or only the surfaces of the sixth side plate 160 and the third side plate 130, or only the surfaces of the sixth side plate 160 and the fourth side plate 140.

In some embodiments, the radiating fin 106 may be disposed on at least one of the first side plate 110, the second side plate 120, the third side plate 130, the fourth side plate 140 and the sixth side plate 160.

In some embodiments, multiple radiating fins 106 are arranged along the first direction X. More radiating fins 106 can provide a stronger heat dissipation capability of the inductor 12. Thus, arranging multiple radiating fins 106 along the first direction X further enhances the heat dissipation capability of the inductor 12.

In some embodiments, a surface of the sixth side plate 160 away from the opening 170 is provided with a groove 107, and part of the radiating fin 106 is disposed on a surface of the groove 107. On one hand, the groove 107 increases the strength of the outer shell 100. On the other hand, by providing the part of the radiating fin 106 on the surface of the groove 107groove 107, a contact area between the radiating fin 106 and the outer shell 100 is increased, further enhancing the heat dissipation capability of the inductor 12.

In the embodiments of the present disclosure, the components in the energy storage converter are protected by the housing 10 and cooled by the liquid cooling plate 11. The outer shell 100 of the inductor 12 is provided to include multiple side plates defining the outer shell 100, so as to protect the inner core 101 of the inductor 12. The fifth side plate 150 is provided with an opening 170, and disposed on the liquid cooling plate 11 so that the opening 170 is oriented toward the liquid cooling plate 11, which reduces a distance between the inner core 101 and the liquid cooling plate 11, thereby increasing a cooling rate of the inner core 101 and improving a heat dissipation efficiency of the inductor in the energy storage converter. Additionally, a wire outlet structure 180 is disposed on a portion of the fifth side plate 150 other than the opening 170 and extends in a direction from the opening 170 to the sixth side plate 160, so that when the fifth side plate 150 is fixed on a surface of the liquid cooling plate 11, electric connection of the output line of the inner core 101 to other structures is facilitated, a position of the output line is fixed, and a design of an installation location of the inductor is also facilitated.

Persons of ordinary skill in the art shall understand that the above embodiments are merely specific and exemplary embodiments for practicing the present disclosure, and in practice, various modifications may be made to these embodiments in terms of formality and detail, without departing from the spirit and scope of the present disclosure. Variations and modifications may be made by one skilled in the art without departing from the spirit and scope of the present disclosure. Accordingly, the protection scope of the present disclosure is subject to the appended claims.

## Claims

1. An energy storage converter, comprising:
a housing (10), internally provided with an accommodating space;
a liquid cooling plate (11), located within the accommodating space; and
an inductor (12), including:
an outer shell (100), wherein the outer shell (100) includes a first side plate (110) and a second side plate (120) arranged along a first direction (X), a third side plate (130) and a fourth side plate (140) arranged along a second direction (Y), and a fifth side plate (150) and a sixth side plate (160) arranged along a third direction (Z), wherein the fifth side plate (150) is provided with an opening (170), a wire outlet structure (180) is disposed on a portion of the fifth side plate (150) other than the opening (170) and extends in a direction from the opening (170) to the sixth side plate (160), and the fifth side plate (150) is fixed on a surface of the liquid cooling plate (11); and
an inner core (101), fixed inside the outer shell (100), wherein an output line of the inner core (101) extends out of the outer shell (100) from the wire outlet structure (180).

2. The energy storage converter according to claim 1, wherein the outer shell (100) further includes: a limiting structure (102), located on a side of the inner core (101) away from the sixth side plate (160) and surrounding the wire outlet structure (180).

3. The energy storage converter according to claim 2, wherein the inner core (101) includes: a magnetic core (111) and a coil (121) surrounding part of the magnetic core (111);
wherein the limiting structure (102) includes:
a fixing portion (112), wherein a surface of the fixing portion (112) facing the sixth side plate (160) abuts the inner core (101); and
a plurality of copper bars (122), fixed on the fixing portion (112), wherein a respective copper bar (122) of the plurality of copper bars (122) is provided with a first through hole (133) penetrating the respective copper bar (122), the first through hole (133) is aligned with the wire outlet structure (180), and the output line is electrically connected to the respective copper bar, and passes through the first through hole (133) to extend into the wire outlet structure (180).

4. The energy storage converter according to claim 3, wherein the limiting structure (102) further includes at least one of a clamping portion (132) and two limiting portions (212);
wherein the clamping portion (132) is fixed on a surface of the fixing portion (112) away from the sixth side plate (160), a second through hole (142) is provided between the clamping portion (132) and the fixing portion (112), and the respective copper bar (122) passes through the second through hole (142) and is fixed on the fixing portion (112); and
wherein the two limiting portions (212) are located on opposite sides of the fixing portion (112) respectively, and each of the two limiting portions (212) abuts both the fixing portion (112) and the magnetic core (111).

5. The energy storage converter according to claim 4, wherein the clamping portion (132) includes:
a plurality of first extending portions (152), extending along the first direction (X), wherein each respective first extending portion (152) of the plurality of first extending portions (152) at least covers a surface of the respective copper bar away from the sixth side plate (160);
a plurality of first bending portions (162), wherein each respective first bending portion (162) of the plurality of first bending portions (162) is connected to one end of the respective first extending portion (152) and extends toward the coil (121) in the second direction (Y); and
at least one second extending portion (172), extending along the first direction (X), wherein each respective second extending portion (172) of the at least one second extending portion (172) is located between two adjacent first extending portions (152) and connected to a respective first bending portions (162), and the respective second extending portion (172) is located on a side of each of the two adjacent first extending portions (152) facing the coil (121).

6. The energy storage converter according to claim 4, wherein each of the two limiting portions (212) includes:
a first contact portion (222), extending along the first direction (X) and abutting the fixing portion (112); and
a second contact portion (232), extending along the third direction (Z) and abutting a part of the magnetic core (111) not surrounded by the coil (121).

7. The energy storage converter according to claim 6, wherein the first contact portion (222) includes:
a plurality of sub-contact portions (242), arranged along the third direction (Z); and
a connecting portion (252), extending along the third direction (Z) and configured to connect the plurality of sub-contact portions (242) together.

8. The energy storage converter according to claim 3, wherein the fixing portion (112) includes:
a bearing portion (182), wherein the plurality of copper bars (122) are fixed on the bearing portion (182); and
an abutting portion (202), located on a surface of the bearing portion (182) facing the sixth side plate (160), wherein in the second direction (Y), a length of an orthographic projection of each of the plurality of copper bars (122) on the bearing portion (182) is greater than a length of an orthographic projection of the abutting portion (202) on the bearing portion (182).

9. The energy storage converter according to any one of claims 1 to 8, wherein the inductor (12) further includes:
a filling layer (104), wherein the filling layer (104) fills the outer shell (100), and the inner core (101) is located between the filling layer (104) and the outer shell (100).

10. The energy storage converter according to claim 9, further comprising:
a heat conduction layer (105), located between the filling layer (104) and the liquid cooling plate (11).

11. The energy storage converter according to any one of claims 1 to 10, wherein the inductor (12) further includes:
a radiating fin (106), fixed on a surface of the outer shell (100).

12. The energy storage converter according to any one of claims 1 to 11, wherein a connection surface between each of at least one of the first side plate (110) and the second side plate (120) and each of the third side plate (130), the fourth side plate (140) and the sixth side plate (160) is rounded.

13. The energy storage converter according to any one of claims 1 to 11, wherein the first side plate (110) is connected to each of the third side plate (130), the fourth side plate (140) and the sixth side plate (160) through a connecting step (190).

14. The energy storage converter according to claim 13, wherein the connecting step (190) includes:
a first connecting side wall (191), connected to the first side plate (110); and
a second connecting side wall (192), connected to each of the third side plate (130), the fourth side plate (140) and the sixth side plate (160), wherein there is an included angle between the first connecting side wall (191) and the second connecting side wall (192).

15. The energy storage converter according to claim 14, wherein the first connecting side wall (191) includes:
a first connecting region (193) in contact with a side surface of the first side plate (110) away from the fifth side plate (150);
a second connecting region (194), connected to the first connecting region (193) and in contact with a side surface of the first side plate (110) on one of two opposing sides of the first side plate (110); and
a third connecting region (195), connected to the first connecting region (193) and in contact with a side surface of the first side plate (110) on the other one of two opposing sides of the first side plate (110).
